# EUROPEAN PATENT SPECIFICATION

(11) **EP 0 706 736 B1**
(45) Date of publication and mention of the grant of the patent: **01.09.1999**
(21) Application number: 94913132.0
(22) Date of filing: 27.04.1994
(51) Int. Cl.: H04L 25/49, H03M 5/18

(54) **A METHOD FOR INCLUDING AUXILIARY DATA IN A DATA SIGNAL ENCODED WITH A BIPOLAR IN-LINE CODE**
VERFAHREN ZUR EINFÜGUNG VON NEBENDATEN IN EIN, MIT EINEM BIPOLAREN LEISTUNGSKODE KODIERTES DATENSIGNAL
PROCEDE D'INSERTION DE DONNEES AUXILIAIRES DANS UN SIGNAL DE DONNEES CODE AVEC UNE SEQUENCE BIPOLAIRE PRINCIPALE

(30) Priority: 28.04.1993 FI 931913
(43) Date of publication of application: 17.04.1996
(73) Proprietor: NOKIA TELECOMMUNICATIONS OY, 02150 Espoo (FI)
(72) Inventor: SUNDQVIST, Mika, FIN-02760 Espoo (FI); SALMELIN, Juha, FIN-02730 Espoo (FI); LEHTO, Hannu, FIN-02150 Espoo (FI)
(74) Representative: Tomlinson, Kerry John
(86) International application number: FI9400162
(87) International publication number: WO9426048

(56) References cited:
- EP-A- 0 136 663
- EP-A- 0 443 712
- DE-C- 3 401 729
- US-A- 4 550 403
- US-A- 4 897 854

## Description

This invention relates to a method for including auxiliary data in a data signal encoded with a bipolar in-line code, comprising recognizing an unambiguously recognizable, predetermined bit pattern from a data signal, and generating an unambiguously recognizable modification in the data signal at least at some of the recognized bit patterns for asynchronously including auxiliary data in the data signal.

A method of the type described above is disclosed e.g. in EP Patent Application 443 712. In the method according to this patent application, bit patterns consisting of four ones or four zeros are searched out. In EP Patent Application 443 712, a sequence of four ones, which in the HDB3 code, for instance, is encoded with alternating polarities (such as +-+- or -+-+), is additionally encoded such that the code is converted into the format ++-- or --++, which does not change the overall DC content of the code, but is recognizable by the two consecutive bits of the same polarity. Similar modifications are suggested for encoding a sequence of four zeros, whereby code violations made on encoding a sequence of four zeros with the HDB-3 code are utilized. Additional encoding is thus performed on an HDB-3-encoded bit stream, and it has to be removed before the encoded data can be restored into the original bit sequence. The method provides three separate channels for auxiliary data when the additional encoding is performed both on sequences of four ones and on sequences of four zeros encoded in two different ways. When all of the channels are used, the auxiliary data transmission rate for an arbitrary bit stream will be 1/8 of the primary data transmission rate. In EP-A-0 136 663 a similar transmission system is disclosed, which en-/de-codes auxiliary data without reducing the original transmission rate of an AMI-coded signal.

The object of the present invention is to provide a new way of including auxiliary data in a data signal encoded with a bipolar in-line code. This way does not have the limitations of the above-described procedure concerning the necessity of the occurrence of code violations and the need to separately remove the additional encoding that has been made. Accordingly, it is applicable not only with HDBn in-line codes, as in the prior art, but also with the AMI in-line code. Another object is to improve the auxiliary data transmission rate.

The above objects are achieved by a method according to the invention, which is characterized in that the generation of the modification comprises changing the polarity of at least one bit in the recognized bit pattern to be encoded with auxiliary data and changing the polarity of all subsequent bits in the data signal.

Preferably, the predetermined bit pattern is one of the following bit patterns: 11, 101 and 111.

In the method according to the invention, only polarity errors, which can be located easily and unambiguously, are caused in an encoded bit sequence. Instead, no modifications are made in the bits of the original bit sequence encoded with a bipolar in-line code, and so the additional encoding performed need not be separately removed. In the additional encoding according to the invention, the encoding rules may be very simple. Encoding may be performed e.g. in such a way that the performance of additional encoding at a bit pattern selected as an object of encoding signifies one, while the non-performance of additional encoding signifies zero.

The use of the way of encoding according to the invention provides one auxiliary data channel, the transmission capacity of which, however, is at the most one fourth of the transmission capacity of the main channel (if the bit pattern 11 is used for encoding). This auxiliary data channel may be used e.g. between two terminal equipments when e.g. control data having a lower rate than the primary signal between processors is to be transmitted between the terminal equipments, and no separate transmission line is available for the control data, or one is not willing to establish such a costly transmission line. The method according to the invention may be applied advantageously e.g. in distributed microwave radios, where there are already two cables between the lower unit (the indoor unit in device spaces) and the upper unit (the unit associated with the antenna in a mast) due to the primary data and the supply of electricity. In the auxiliary data channel according to the invention the processors of the upper and lower unit communicate, forwarding control and state data. In practice, the provision of two additional cables between the upper and lower units is thus avoided.

The encoding according to the invention is based on an unambiguously recognizable, predetermined bit pattern, which preferably does not form part of violation encoding possibly included in the bipolar in-line code. Unencoded data must not either be similar to encoded data, that is, bit patterns produced after the encoding according to the invention must not, of course, occur in a normal code. Bit patterns meeting the above-mentioned definitions include the bit patterns 11, 101 and 111. There is, of course, a greater number of bit patterns suitable for encoding according to the invention, but they have a greater number of bits, and the probability of occurrence is thus smaller, which results in a reduction in the transmission rate. Accordingly, they are not as advantageous in use as the above-mentioned bit patterns. The bit pattern 101 is especially advantageous, as will be described below.

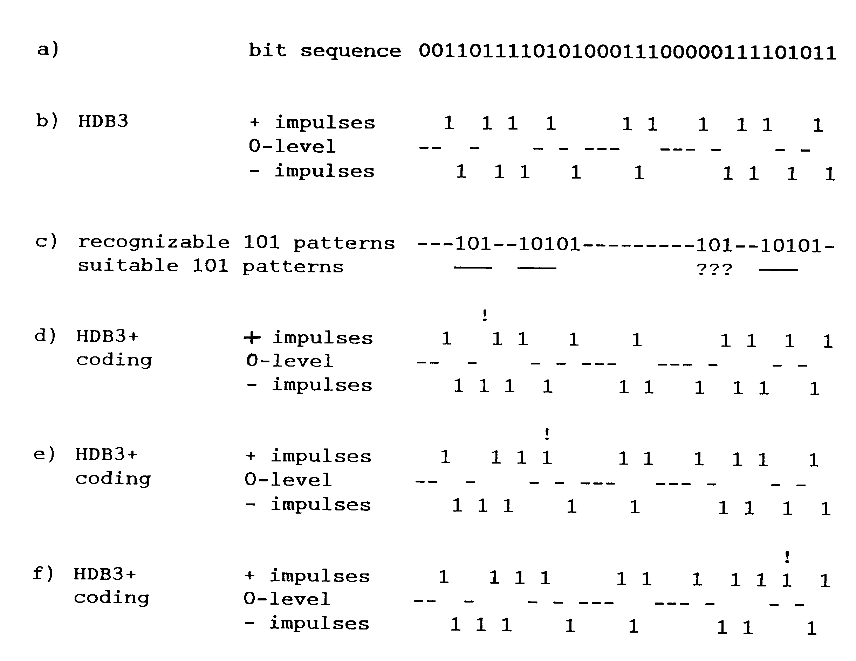

In the following the method according to the invention will be described more fully in connection with 101 bit patterns and with reference to the attached figure, where
item a) shows the original bit sequence;
item b) shows the bit sequence of item a) after encoding with the HDB3 in-line code;
item c) shows 101 bit patterns picked out of the in-line encoded bit sequence of item b);
item d) shows the additional encoding according to the invention performed at the first 101 bit pattern:
item e) shows the additional encoding according to the invention performed also at the second 101 bit pattern; and
item f) shows the additional encoding according to the invention performed also at the third 101 bit pattern.
Item a) of the figure shows a binary bit sequence consisting of arbitrarily alternating zeros and ones. When the bit sequence of item a) is encoded in accordance with the HDB3 code, the bit pattern of item b) is obtained. First, the ones of the original bit sequence have been encoded alternately into plus impulses and minus impulses. Second, code violations according to the HDB3 in-line code have been realized in the bit sequence whenever there occurs four consecutive zero bits in the sequence.
Item c) of the figure shows sections with the bit pattern 101 to be found in the bit sequence encoded as shown in item b). There are six such 101 bit patterns when the bit sequence 10101 is interpreted as two bit patterns.

The recognized 101 patterns are then searched for patterns suitable for use as objects of the encoding according to the invention. In item c) of the figure, these suitable bit patterns have been underlined. As appears from the figure, only the bit pattern 10101 formed by the three first bits has been selected for encoding from the bit patterns, as any unnecessary increase in the DC component is thus avoided, which would result from the encoding of the latter bit pattern. In item c), the three question marks indicate a bit pattern the first one impulse of which has been generated as a result of a code violation according to the HDB3 in-line code and thus has the same polarity as the preceding one impulse. This 101 bit pattern is not particularly well suited for the encoding according to the invention, as it would result in an undesired combination of three consecutive one impulses with the same polarity, wherefore it has also been excluded from the suitable bit patterns. The end result will thus be that only three out of the six 101 bit patterns that have been found are suitable for the encoding according to the invention. Accordingly, the bit sequence of item a) is able to transfer three bits of auxiliary data.

Item d of the figure shows how the encoded data changes when the additional encoding according to the invention is performed at the first 101 bit pattern regarded as suitable in item c). If the above-mentioned procedure is applied as the encoding rule, i.e. the performance of encoding signifies one and the non-performance signifies zero, the bit pattern shown in item c) corresponds to auxiliary data 100. According to the invention, the additional encoding means that the polarity of the last bit of the 101 bit pattern is changed as well as the polarities of all subsequent bits. Accordingly, the in-line code of item d) corresponds to the in-line code shown in item b) for the five first bits, but after this point the polarity of all subsequent ones has been changed. This point of change is indicated by an exclamation mark in item d) of the figure.

In item e) of the figure the starting point is the bit pattern of item d), and the additional encoding according to the invention has also been performed at the second 101 bit pattern. This second encoding point is also indicated by an exclamation mark in item e). In item d), the content of auxiliary data will be 110.

As can be seen by comparing the bit patterns of items e) and d), the polarity of all one bits has been changed beginning from the point indicated with the exclamation mark. Furthermore, the encoding has been performed in item f) at the third 101 bit pattern regarded as suitable. Even in this case the starting point of the encoding is indicated with an exclamation mark. The in-line codes of items e) and f) of the figure thus correspond to each other up to the exclamation mark occurring in item f), whereafter all one bits in the code have been inverted. In item f), the content of auxiliary data will be 111.

The method according to the invention has been illustrated above only in connection with one bit pattern suitable for the purpose, i.e. the bit pattern 101. In the same way the method according to the invention could also be used in connection with the bit patterns 11 and 111 when considering bit patterns having 2 or 3 bits. Due to the shortness of the required bit pattern the transmission rate can be increased nearly to one fourth of the transmission rate of primary data, if the 11 bit pattern is used. In the method according to the invention, when it is applied to the bit pattern 101, there will never occur two consecutive bits with the same polarity, which, however, is typical of the prior art ways of encoding an auxiliary channel as well as of the method according to the invention when applied to the bit patterns 11 and 111.

As is to be seen from items b), d), e) and f), the encoding according to the invention does not change the bits of the original code, so that the encoded bit stream can be restored into the original data without first having to remove the additional encoding. This is not possible in the prior art methods.

As already mentioned above, the method according to the invention, unlike most prior art methods, does not utilize the violation encoding of the in-line code, and so the way of encoding according to the invention is also suitable for use with the AMI (Alternate Mark Inversion) in-line code. Similarly, it can be applied directly to HDBn in-line codes.

## Claims

1. Method for including auxiliary data in a data signal encoded with a bipolar in-line code, comprising
recognizing an unambiguously recognizable, predetermined bit pattern from a data signal, and
generating, by utilizing polarity changes of the bits in the data signal, an unambiguously recognizable modification in the data signal at least at some of the recognized bit patterns for asynchronously including auxiliary data in the data signal, **characterized** in that
the generation of the modification comprises changing the polarity of at least one bit in the recognized bit pattern to be encoded with auxiliary data and changing the polarity of all subsequent bits in the data signal.

2. Method according to claim 1, **characterized** in that the predetermined bit pattern is one of the bit patterns 11, 101 and 111.

## Patentansprüche

1. Verfahren zum Einfügen von Nebendaten in ein mit einem bipolaren Leitungskode kodiertes Datensignal, mit den Schritten
Erkennen eines eindeutig erkennbaren, vorbestimmten Bitmusters eines Datensignals, und
Erzeugen einer eindeutig erkennbaren Abwandlung in dem Datensignal zumindest bei einigen der erkannten Bitmuster durch Verwendung von Polaritätsänderungen der Bits in dem Datensignal, um Nebendaten in das Datensignal asynchron einzufügen,
**dadurch gekennzeichnet, daß**
die Erzeugung der Abwandlungen ein Ändern der Polarität von zumindest einem Bit in dem erkannten, mit Nebendaten zu kodierenden Bitmuster und der Polarität aller nachfolgenden Bits in dem Datensignal aufweist.

2. Verfahren nach Anspruch 1,
**dadurch gekennzeichnet, daß**
das vorbestimmte Bitmuster eines der Bitmuster 11, 101 und 111 ist.

## Revendications

1. Procédé pour intégrer des données auxiliaires dans un signal de données encodé avec un code bipolaire direct comprenant les étapes consistant à :
reconnaître à partir d'un signal de données une configuration binaire prédéterminée, reconnaissable sans ambiguïté, et
générer, en utilisant des changements de polarité des bits du signal de données, une modification du signal de données, reconnaissable sans ambiguïté, au moins dans certaines des configurations binaires reconnues pour intégrer d'une manière asynchrone des données auxiliaires dans le signal de données, caractérisé en ce que :
la réalisation de la modification comprend un changement de la polarité d'au moins un bit dans la configuration binaire reconnue à encoder avec des données auxiliaires et la polarité de tous les bits suivants du signal de données.

2. Procédé selon la revendication 1, caractérisé en ce que la configuration binaire prédéterminée est l'une des configurations binaires 11, 101 et 111.
